# EUROPEAN PATENT SPECIFICATION

(11) **EP 1 285 455 B1**
(45) Date of publication and mention of the grant of the patent: **21.09.2005**
(21) Application number: 01930578.8
(22) Date of filing: 18.04.2001
(51) Int. Cl.: H01J 37/02, H01J 37/317, H01J 37/244

(54) **METHOD AND APPARATUS FOR PARTICLE DETECTION USING A SENSOR STRUCTURE HAVING A MOVEABLE PORTION**
VERFAHREN UND VORRICHTUNG ZUR PARTIKELWAHRNEHMUNG MITTELS EINER SENSORANORDNUNG MIT BEWEGLICHEM TEIL
PROCEDE ET APPAREIL DE DETECTION DE PARTICULES A L'AIDE D'UNE STRUCTURE DE DETECTION PRESENTANT UNE PARTIE MOBILE

(30) Priority: 25.05.2000 US 578981
(43) Date of publication of application: 26.02.2003
(73) Proprietor: Varian Semiconductor Equipment Associates Inc., Gloucester, MA 01930 (US)
(72) Inventor: FANG, Ziwei, Beverly, MA 01915 (US); WALTHER, Steven, R., Andover, MA 01810 (US); FELCH, Susan, B., Los Altos Hills, CA 94022 (US); SONICO, Juanita, S., Sunnyvale, CA 94087 (US)
(74) Representative: Beck, Simon Antony
(86) International application number: PCT/US2001/012662
(87) International publication number: WO 2001/093304

(56) References cited:
- DE-A- 4 444 647
- PATENT ABSTRACTS OF JAPAN vol. 018, no. 384 (P-1772), 19 July 1994 (1994-07-19) & JP 06 109856 A (HITACHI LTD), 22 April 1994 (1994-04-22)
- PATENT ABSTRACTS OF JAPAN vol. 014, no. 569 (P-1144), 18 December 1990 (1990-12-18) & JP 02 245632 A (OLYMPUS OPTICAL CO LTD), 1 October 1990 (1990-10-01)

## Description

### FIELD OF THE INVENTION

This invention relates to detecting moving particles using a sensor structure having a movable portion. The invention can be useful in detecting charged particles in an ion beam used to introduce impurities into a semiconductor wafer.

### BACKGROUND OF THE INVENTION

Detecting small moving particles, e. g., particles ranging from the size of a single atom to approximately 0.1 micrometers, can be useful in many different applications. One such application is in ion implantation systems that implant energetic ions into relatively larger workpieces, such as semiconductor wafers. As is known to those skilled in ion implantation, or doping, art, implanting ions or other particles into a semiconductor material is widely used to make semiconductor devices.

Two important factors in ion implantation are uniformity of the ion. implantation over the workpiece surface and ensuring that the ions are incident on the workpiece at a constant, or nearly constant, incident angle. One method for determining the uniformity of implantation uses a Faraday profiler that is scanned along a plane where a semiconductor wafer surface is positioned during implantation, such as that disclosed in U. S. Patent 4,922,106 to Berrian et al. Intensity variations in the ion beam are detected by the profiler and are used to make uniformity adjustments in the beam. Although such techniques provide satisfactory results, they are typically slow and require relatively expensive special purpose equipment. Thus, a simpler and more cost-effective technique is needed to detect particles in a beam, such as a charged particle beam.

DE 4444647 discloses a one sided micro-leaf spring which acts like a ballistic pendulum, and hence the impact of particles on the pendulum's free end causes it to bend. Movement of the pendulum is detected by a change in the reflected direction of a light beam.

### SUMMARY OF THE INVENTION

According to a first aspect of the present invention there is provided a method for detecting ions in an ion beam, comprising: providing at least one cantilever arm having a fixed portion fixed relative to a substrate and a movable portion movable relative to the substrate; directing an ion beam suitable for implanting ions in a semiconductor wafer toward the cantilever arm; characterised by detecting movement of the movable portion relative to the substrate in response to ions in the ion beam changing an electrical charge of at least a portion of the cantilever arm.

According to a second aspect of the present invention there is provided a particle detector for use with an ion implantation device, the particular detector comprising: at least one sensor structure, each sensor structure having a fixed portion fixed relative to a reference surface and a movable portion; characterised by a sensor that detects movement of the movable portion of the sensor structure in response to ions in an ion beam suitable for implanting in a semiconductor wafer impacting the sensor structure and changing an electrical charge of the sensor structure.

It can be seen that the invention provides a method and apparatus for detecting particles, especially particles in a particle beam. The invention provides a sensor structure having a movable portion that deflects or otherwise moves when the structure is impacted by moving particles. The particles can be charged particles and can have various sizes and energies. For example, the particles can be single atoms or groups of multiple atoms, e.g., up to 0.1 micrometers in size and larger. Particle impact on the sensor structure movable portion causes at least a portion of the structure to deflect based on charge transfer from the impacting particles.

The sensor structure is preferably a micromachined device made using conventional photolithography techniques, although other techniques and larger sensor structures are possible. As one example, the sensor structure can be a cantilever arm that has a fixed portion fixed to a substrate and a movable portion that is connected to the fixed portion, but is spaced from and otherwise not connected to the substrate. The movable portion of the cantilever arm is constructed so that when it is impacted by a particle or particles, the arm deflects based on a charge transfer from the particle or particles to the arm. When the arm is intended to detect the presence of very small particles, the arm is made sufficiently flexible so that the presence of such small particles can be detected. However, if the arm is intended to detect larger particles, the movable portion can be made more robustly, e. g., more stiffly, so that the presence of the larger particles can be detected without damage to the arm. In addition, more robust construction of the arm can prevent or reduce the likelihood of detection of smaller particles.

Deflection of the arm can be detected in various ways, including directing a beam, such as a laser beam, at a reflecting surface of the movable portion of the arm. Portions of the beam reflected by the arm can be detected by a photodetector or other light sensitive element. When the arm is deflected a change in direction of the reflected beam is detected by the photodetector. By detecting the change in direction of the reflected beam, the detector can output a signal representing the amount and/or direction of the arm's deflection. Movement detection of the arm can be calibrated so that a given amount of detected movement indicates a total amount of charge has been deposited on the arm.

Movement of an arm can be detected in other ways. In one embodiment of the invention, movement of an arm can cause an electrical switch to be closed, thus allowing detection of movement of the arm based on the detected switch state. As one example, impact of a particle or particles on an arm can cause the arm to deflect downwardly toward an underlying substrate. If movement of the arm is sufficient, one or more portions of the arm may contact an electrical contact on the substrate, thus closing an electrical switch. Closing of the electrical switch may be detected by a controller or other device and indicate a number of particles, a total charge amount, etc. has impacted or is present on the arm.

Movement of the arm can be detected in other ways, including detecting a change in capacitance of a capacitor formed by a portion of the arm and a device, such as a corresponding capacitor plate, formed on the substrate. Thus, when the arm moves as a result of an accumulation of electrical charge on the arm possibly in combination with momentum transfer, a corresponding change in capacitance can be detected. Of course, other detection techniques can be used, if desired.

Although a cantilever arm is preferably used to detect the presence of a particle or particles, other sensor structures can be used in accordance with the invention. For example, in one aspect of the invention, a bridge-type or diaphragm-type structure is used to detect a particle or particles. In a bridge-type sensor structure, two ends of a flexible beam are attached to a substrate so that a central portion of the beam moves when impacted by a particle or particles. Movement of the central portion can be detected in any desired way, including those described above. In a diaphragm-type sensor structure, a circular-shaped disk or other shaped, approximately flat structure can be attached to a substrate so that a central portion of the structure is positioned over a cavity formed in the substrate. Thus, the central portion of the sensor structure is free to move when impacted by a particle or particles. Movement of the central portion can be detected in any desired way, including those described above.

According to a third aspect of the present invention, there is provided an ion implantation device comprising: the particle detector according to the first or second aspect of the present invention; and an ion beam generator; wherein the sensor structure is positioned near a workpiece plane to detect particles in an ion beam produced by the ion beam generator.

### BRIEF DESCRIPTION OF THE DRAWINGS

The invention is described below in connection with the following drawings in which like reference numerals refer to like elements, and wherein:
Figure 1 is a schematic block diagram of a particle detection device in accordance with an embodiment of the invention;
Figure 2 is a top view of an exemplary cantilever arm arrangement;
Figure 3 is a top view of an exemplary array of cantilever arms;
Figure 4 is a side view of a cantilever arm positioned over a cavity in an underlying substrate;
Figure 5 is a side view of a cantilever arm having two free ends;
Figure 6 is a side view of a cantilever arm having two free ends positioned over respective cavities in an underlying substrate ;
Figure 7 is a side view of a sensor structure positioned over a cavity in a substrate;
Figure 8 is a schematic block diagram of a laser detection device for detecting movement in an array of sensor structures;
Figure 9 is a schematic block diagram of an alternate laser detection device;
Figure 10 is a schematic diagram of an arm movement detector using an electronic switch;
Figure 11 is a schematic diagram of an arm movement detector using a change in capacitance to detect movement;
Figure 12 is a schematic diagram of a particle detection device that detects particle impact using secondary electron emission; and
Figure 13 is a flow chart of steps of a method for detecting particles in a beam.

### DETAILED DESCRIPTION

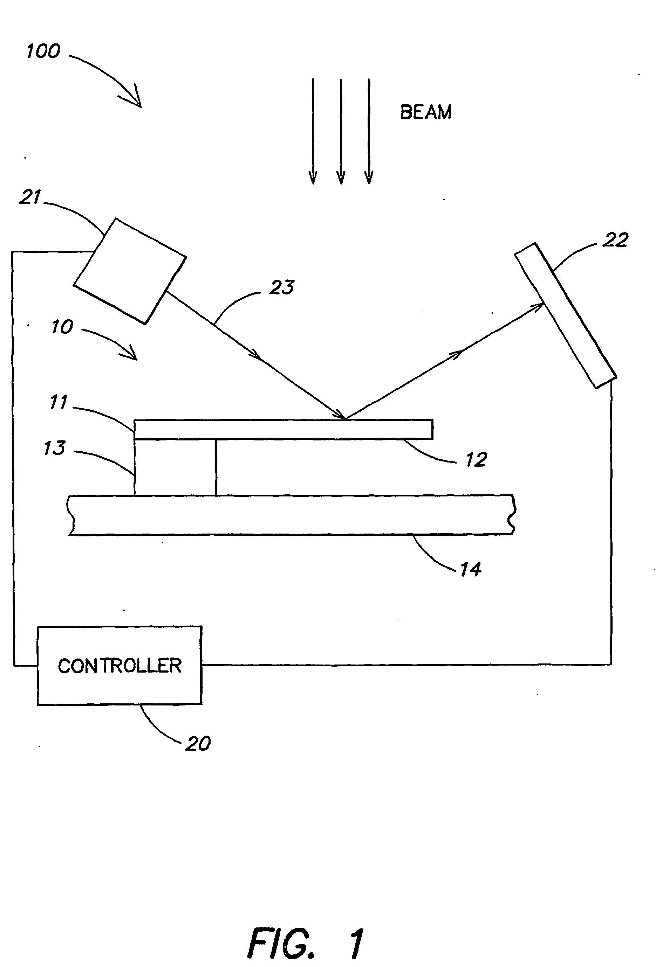

Figure 1 shows a schematic block diagram of a particle detection device 100 in accordance with an embodiment of the invention. In this example, a sensor structure 10 is a cantilever arm having a fixed portion 11 and a movable portion 12. The fixed portion 11 is fixed to a spacer 13, which is fixed to a substrate 14. The sensor structure 10 is preferably made of polysilicon, although other semiconductive, conductive or insulating materials can be used, if desired. However, the sensor structure 10 is preferably a material that allows the sensor structure 10 to elastically deform when impacted by one or more particles. The spacer 13 is preferably made from a layer of insulating material, such as silicon dioxide, but other materials are possible. The substrate 14 is preferably a silicon material, such as single crystalline silicon, but as with the other structures, other materials are possible.

The sensor structure 10 is preferably made using well-known photolithography, etching and other fabrication techniques common to making micromachined structures. For example, an insulating layer may be deposited on the substrate 14 along with a layer of photoresist. The photoresist may be exposed to a desired pattern of electromagnetic radiation and etched to form the spacer 13. Next, one or more layers can be deposited along with photoresist, and the layers can be exposed to a pattern of light and etched to form the sensor structure 10. Of course, other techniques can be used to form the sensor structure 10.

The particle detection device 100 also includes a controller 20 that controls the operation of and/or receives information from a beam emitter 21 and a detector 22. The beam emitter 21 in this example is a laser beam emitter, although other light sources can be used if desired. The controller 20 is shown as controlling the operation of the beam emitter 21, although such control is optional. That is, the beam emitter 21 could be a stand alone device that is not controlled by the controller 20. In addition, the controller 20 need not perform any control functions if desired. Instead, the controller 20 could function only to receive a signal from the detector 22 and process the signal, e.g., create a display, store the signal, determine that the sensor structure 10 has moved, determine a particle size that caused the sensor structure 10 to move, etc. The beam emitter 21 emits a beam 23 of radiation that is reflected by the movable portion 12 of the sensor structure 10 to the detector 22. In this example, the detector 22 is a video camera, although other devices, such as CCD arrays, silicon photodiodes, or other light sensitive devices can be used as the detector 22. As the sensor structure 10 moves, the reflected beam 23 moves relative to the detector 22. The detector 22 outputs a signal to the controller 20, which can determine an amount of deflection of the movable portion 12 of the sensor structure 10 based on the signal from the detector 22. In this example, the controller 20 performs an image analysis on the signal from the detector 22 to determine an amount of deflection of the movable portion 12. However, such image analysis is not required, e.g., if a video camera is not used for the detector 22, and instead the detector 22 may include a linear or two-dimensional array of sensors that each output a discrete signal indicating when a particular sensor is illuminated by the beam 23, or otherwise output a signal that represents an amount of movement of the reflected beam 23 relative to the detector 22. Such information may be used by the controller 20 to determine the relative position of the beam 23 with respect to the detector 22, and thus determine an amount of deflection of the movable portion 12.

The controller 20 is preferably a general purpose data processing system, which can be a general purpose computer, or network of general purpose computers, and other associated devices, including communications devices, modems, and/or other circuitry or components necessary to perform the desired input/output or other functions. For example, the controller 20 may be part of an ion implantation device controller. The controller 20 can also be implemented, at least in part, as a single special purpose integrated circuit (e.g., ASIC) or an array of ASICs, each having a main or central processor section for overall, system-level control, and separate sections dedicated to performing various different specific computations, functions and other processes under the control of the central processor section. The controller 20 can also be implemented using a plurality of separate dedicated programmable integrated or other electronic circuits or devices, e.g., hard wired electronic or logic circuits such as discrete element circuits or programmable logic devices. The controller 20 can also include any other components or devices, such as user input/output devices like monitors, displays, printers, a keyboard, a user pointing device, touch screen, etc.

In operation, a particle beam shown in Figure 1 as propagating from the top of the figure toward the bottom, is incident on at least a portion of the movable portion 12 of the sensor structure 10. Individual particles in the beam, such as individual atoms or large groups of atoms up to and possibly exceeding 0.1 micrometers in size, impact the movable portion 12. The movable portion 12 can be deflected by the impacting particles in at least two ways. A first way is for the incoming particles to transfer momentum to the movable portion 12 so that the movable portion 12 momentarily bends downwardly toward the substrate 14. Preferably, the movable portion 12 elastically deforms as a result of momentum transfer from the particles. Thus, although the movable portion 12 deflects downwardly upon particle impact, the movable portion 12 later returns to its undeflected state. As can be seen in Figure 1, deflection of the movable portion 12 from its undeflected position causes the beam 23 to be reflected by the movable portion 12 in a different direction and to illuminate a different portion of the detector 22.

Movement of the movable portion 12 due to momentum transfer can indicate the size of a particle or particles that impact the movable portion 12, a kinetic energy of the impacting particle(s), a frequency of impacting particles of a particular size, etc. This information can be used in various ways, such as determining whether and/or where unacceptably large particles are present in an ion implantation beam and the frequency of the particles' occurrence.

A second way that the movable portion 12 can be deflected either downwardly toward the substrate 14 or away from the substrate 14 is that impacting charged particles, such as ions, in the beam accumulate on the movable portion 12 and charge the movable portion 12 either positively or negatively. This charge on the movable portion 12 can cause the movable portion 12 to be electrostatically attracted toward or repulsed away from the substrate 14. When the movable portion 12 is electrostatically attracted toward or repulsed away from the substrate 14, at least a portion of the movable portion 12 and the substrate 14 is preferably electrically conductive and electrically isolated. Typically, the movable portion 12 will attracted to the substrate 14 regardless of the polarity of the charge on the movable portion 12 since a charge in the substrate 14 that is opposite the charge on the movable portion 12 will accumulate. However, it is possible that the substrate 14 could be charged with a same polarity as the charge on the movable portion 12, causing the movable portion 12 to be repulsed away from the substrate 14.

When the movable portion 12 is electrostatically moved, the amount that the movable portion 12 is deflected away from its resting position, e.g., its uncharged or neutral charge position, is an indication of the number and/or the charge of particles that impact the movable portion 12. Such information can be useful, for example, in determining a density of charged particles in a beam per unit area, a number of charged particles deposited in a given area over a certain period of time, a particle beam uniformity, an ion beam current, etc. For example, one or more sensor structures 10 could be scanned across the path of a particle beam (or the particle beam could be scanned across the sensor structures 10), and measurements of the beam's uniformity, e.g., constancy of beam intensity, could be made based on detected deflection of the sensor structures 10. Based on the detected beam characteristics, adjustments to the beam or other system operation, e.g., a scan rate of a wafer in a ion implantation system, may be made.

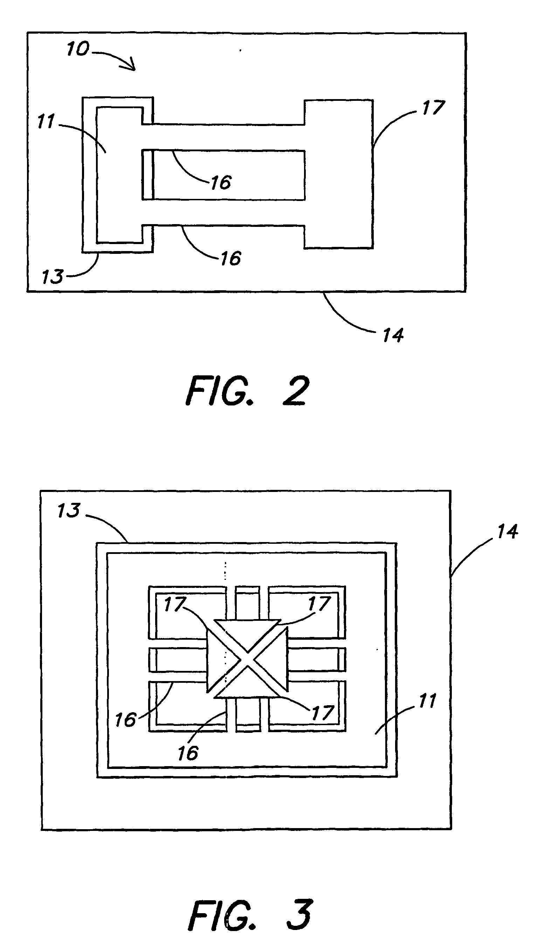

The sensor structure 10 can take a variety of different forms depending upon the nature of the particles to be detected, the detection environment, the desired sensitivity of the detection device, etc. Figure 2 shows a top view of a sensor structure 10 for use in detecting charged particles in an ion implantation device. In this example, the sensor structure 10 includes a pair of arms 16 that extend from the fixed portion 11. The arms 16 carry a pad 17. In this application, the sensor structures 10 are positioned along a plane where a workpiece, such as a silicon wafer, is to be positioned for ion implantation. In fact, the sensor structures 10 may be formed on a silicon wafer that is loaded into an ion implantation system and positioned as if the wafer were to be implanted. While in this position, the wafer (now particle detector) can be used to determine various aspects of the ion beam, including beam uniformity, particle size uniformity, the presence of relatively large particles in the beam, etc. The sensor structures 10 can also be positioned adjacent to an actual semiconductor wafer during ion implantation to provide real-time information regarding the ion beam.

The width, thickness and length of the arms 16 can vary depending upon the application. Similarly, the size and thickness of the pad 17 can vary. In a preferred embodiment for use with ion beams, the arms 16 are made of polysilicon and have a width of 2.5 - 10 micrometers, a thickness of 0.5 - 5 micrometers and length of 40 - 80 micrometers, and the pad has a total area of 1000 - 6250 micrometers². Of course, the arms 16 and pad 17 may have other dimensions within the scope of the invention. In general, the sensor structure 10 design, including selection of constituent materials, configuration and dimensions, is influenced by the desired sensitivity, flexibility or robustness of the movable portion 12. For example, if a sensor structure 10 should be extremely sensitive and robust (e.g., can withstand impact of relatively large particles), the movable portion 12 could be made of a highly elastic material and have relatively small dimensions so that the movable portion 12 moves a detectable amount when impacted by relatively small particles, but will not plastically deform or break when impacted by relatively large particles or otherwise receiving rough treatment. Other design features could also be used, such as movable portion 12 travel stops that prevent the movable portion 12 from moving beyond its elastic or other failure limit

Figure 3 shows an alternate arrangement for the sensor structure 10. In this example, an array of four sensor structures 10 are arranged so that the movable portions 12 extend from a common fixed portion 11 toward a center of the array. Similar to the Figure 2 arrangement, each sensor structure 10 includes a pair of arms 16 that carry a triangular-shaped pad 17. As with the Figure 2 arrangement, it should be understood that the sensor structures 10 can include only a single arm or more than two arms 16, the pads 17 can have any desired shape, and the arms 16 and the pads 17 can have any desired dimensions, depending upon the specific particle detection application. One advantage of the Figure 3 arrangement is that the measured deflections for the four sensor structures 10 can be averaged to provide a potentially more accurate measurement of the number of particles or total charge of particles that impact the sensor structures 10.

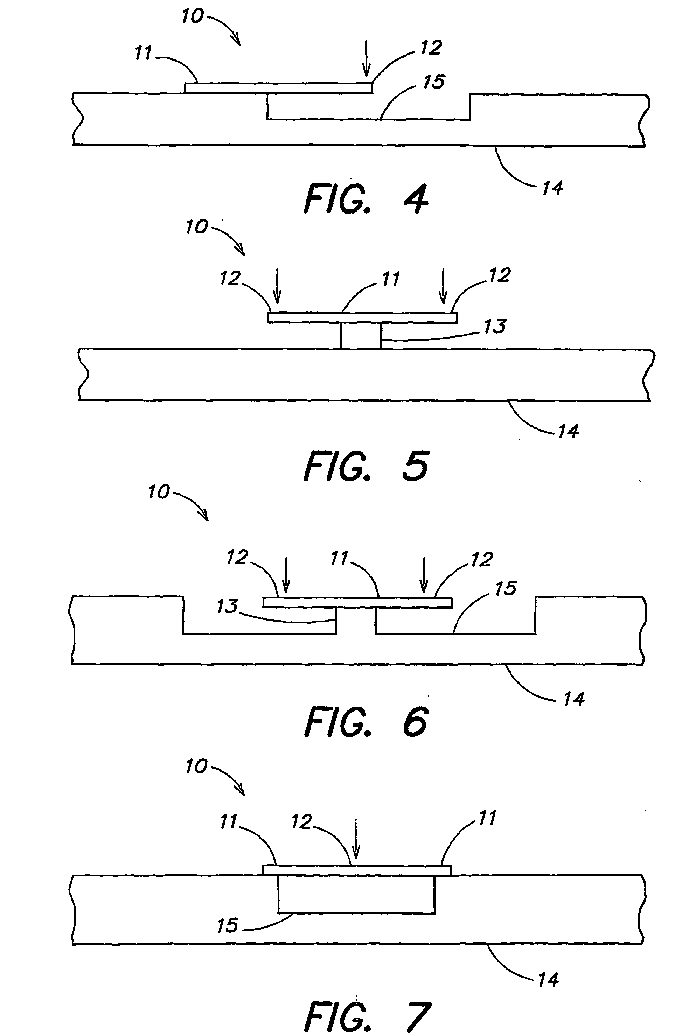

Figure 4 shows an alternate arrangement of a sensor structure 10. In this example, the fixed portion 11 of the sensor structure 10 is fixed directly to the substrate 14 without any intervening spacer, and the movable portion 12 is positioned over a cavity 15 formed in the substrate 14. With this arrangement, the sensor structure 10 can have a lower profile than the structure shown in Figure 1, and possibly avoid detachment from the substrate 14 based on a failure in the connection between the spacer 13 and either the substrate 14 or the fixed portion 11. If the sensor structure 10 is to be electrically isolated from the substrate 14, an intervening insulating layer (not shown) may be provided between the fixed portion 11 and the substrate 14. Alternately, the upper portion of the substrate 14 may be processed or otherwise treated to form an insulating layer, such as a silicon dioxide layer, on the upper surface of the substrate 14. Of course, as discussed above, the substrate 14 may be made of an insulating material, if desired.

A top view of the sensor structure 10 shown in Figure 4 may have an appearance much like that shown in Figure 2, or the sensor structure 10 may have other profiles. For example, the movable portion 12 may simply include a rectangular arm section without any pad 17 as shown in Figure 2. Since the sensor structure 10 is typically made by photolithography techniques, the sensor structure 10 is not limited to any particular arrangement shown or described herein. Instead, the sensor structure 10 can have any desired arrangement, as long as some portion of the sensor structure 10 can move in response to being impacted by particles in a beam.

Figure 5 shows another arrangement of a sensor structure 10. In this example, the sensor structure 10 has a fixed portion 11 attached to a spacer 13 on a substrate 14. Two movable portions 12 extend in opposite directions from the fixed portion 11. Thus, in this example, the sensor structure 10 can have two or more movable portions 12 extending from a common fixed portion 11. That is, the sensor structure 10 may be a beam-like structure that has two movable portions 12 extending from the fixed portion 11. In addition, the sensor structure 10 may have multiple movable portions 12 extending radially from a central fixed portion 11, similar to spokes extending from a central hub on a wheel. Other configurations will occur to those of skill in the art.

Figure 6 shows another arrangement of a sensor structure 10. This example is similar to that shown in Figure 5, except that the spacer 13 is set in a cavity 15 in the substrate 14. As a result, the sensor structure 10 can be in alignment with a top surface of the substrate 14, for example. As with the example in Figure 5, two or more movable portions 12 can extend from a central or common fixed portion 11 in any desired arrangement. For example, the sensor structure 10 may include radially extending arms of different lengths, thicknesses, widths, etc. and therefore have different detection sensitivities. Thus, a single sensor structure 10 may be used to detect particles of different sizes or charges, or to detect beams having different charged particle densities, etc.

Figure 7 shows another arrangement of a sensor structure 10. In this example, the sensor structure 10 has two fixed portions 11 attached to a substrate 14 on opposite sides of a cavity 15. Thus, the movable portion 12 is located between the two fixed portions 11. Of course, the sensor structure 10 need not be positioned over a cavity 15, but instead may be attached to two spacers 13 fixed to the substrate 14. The sensor structure 10 can have a beam-like arrangement, e.g., an elongated beam having a rectangular cross-section, or any other configuration. For example, the sensor structure 10 may be a circular disk that is attached at its periphery to the substrate 14 over a circular cavity 15. In this diaphragm-like arrangement, the central movable portion 12 of the disk-shaped sensor structure 10 can move toward and away from the substrate 14 in response to impacting particles. In a diaphragm-like arrangement, the sensor structure 10 need not have a circular shape, but instead may be rectangular, a regular or irregular polygon, or any other shape. In addition, the thickness of the sensor structure 10 can vary as desired to provide any desired movement response to impacting particles. Furthermore, the sensor structures 10 described above need not be made of a single material. Instead, the sensor structures 10 may be made from two or more materials to achieve different particle detection response characteristics, durability requirements, etc. For example, the sensor structure 10 may be made of an insulating material that is coated with a conductive material in desired areas, e.g., the movable portion 12 of the sensor structure 10. In addition, slots, grooves, or other physical features can be formed in the sensor structures 10 to adjust the structures' 10 sensitivity or other characteristics.

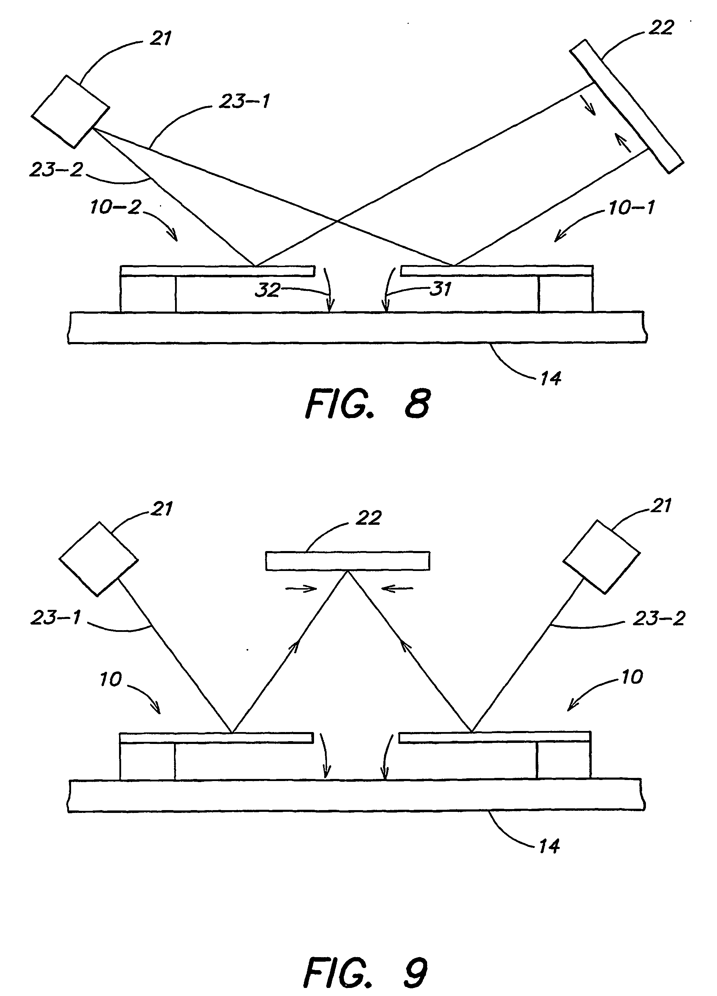

As discussed above, deflection of the sensor structures 10 can be detected in various ways. Figure 8 shows one example where a beam 23 produced by a beam emitter 21 is scanned across multiple sensor structures 10 to detect deflection of the sensor structures 10. In this example, the beam 23 is scanned from a first position 23-1 to a second position 23-2 to detect movement of a first sensor structure 10-1 and the second sensor structure 10-2. As the movable portion 12 of the sensor structure 10-1 moves downward as shown by the arrow 31 in Figure 8, the beam 23 in the first position 23-1 is reflected so that it illuminates portions of the detector 22 closer to a center of the detector 22. Similarly, movement of the movable portion 12 of the sensor structure 10-2 downward as shown by the arrow 32 in Figure 8 causes the beam 23 in the second position 23-2 to be reflected so that it illuminates portions of the detector 22 near the center of the detector 22. Thus, as the sensor structures 10-1 and 10-2 move downward, the illuminated portions on the detector 22 move closer together. Using this arrangement, a distance between the illuminated portions on the detector 22 can be used to determine the actual or average deflection of the sensor structures 10-1 and 10-2.

Figure 9 shows an alternate arrangement for detecting movement of a pair of sensor structures 10. In this example, two beam emitters 21 emit beams 23-1 and 23-2. The beams 23-1 and 23-2 are reflected by the respective sensor structures 10 and are incident on a detector 22. When the sensor structures 10 are in an undeformed state shown in Figure 9, the beams 23-1 and 23-2 illuminate a point on the detector 22. However, as the sensor structures deflect downward in response to impact of particles, the beams 23-1 and 23-2 move as shown by the arrows in Figure 9 away from a central portion of the detector 22. As in the example shown in Figure 8, the distance between the illuminated portions on the detector 22 can be used to determine an actual or average deflection of the sensor structures 10. The arrangement shown in Figure 9 may be difficult to implement unless the detector 22 is part of a micromachined structure, e.g., is formed as part of the process of making the sensor structures 10. The beams 23-1 and 23-2 can also be directed toward the movable portions 12 at different angles, such as perpendicular to the movable portions 12 in an undeflected state. Thus, the detector 22 could only detect the beams 23-1 and 23-2 when the movable portions 12 are deflected toward the substrate 14.

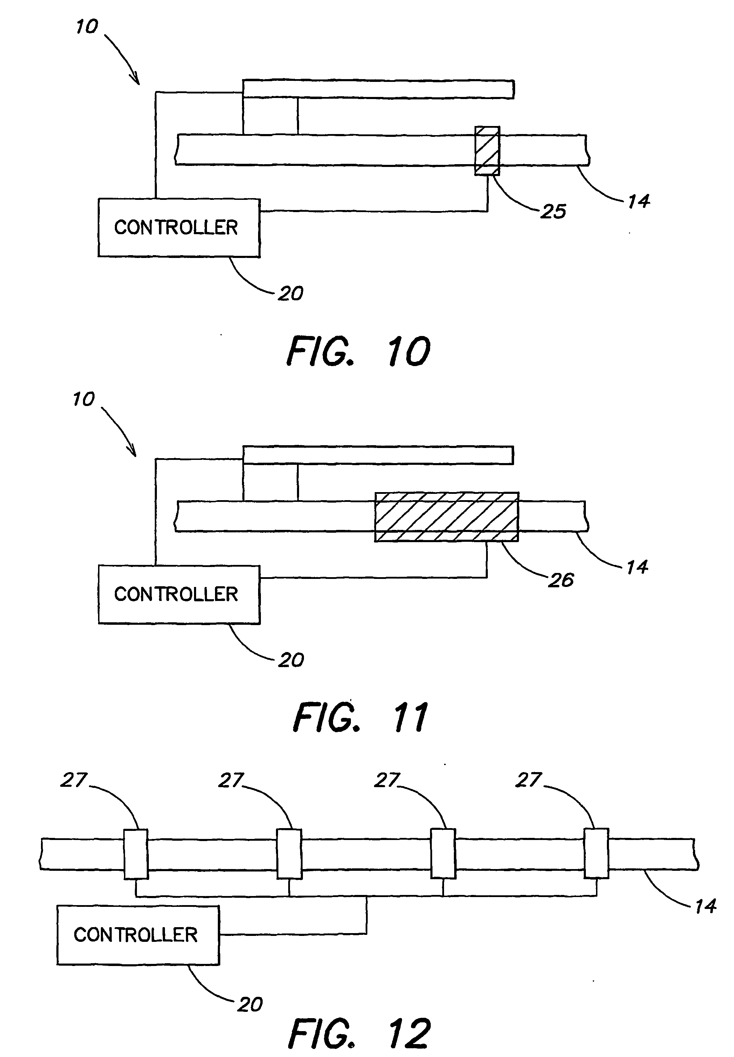

Figure 10 shows a sensor structure 10 that deflects downwardly in response to being impacted by particles. When the sensor structure 10 deflects downwardly a sufficient distance, the sensor structure 10 activates a switch element 25 formed in or on the substrate 14. The switch element 25 can be made of any conductive material, such as a conductive metal. Thus, if the sensor structure 10 deflects downwardly and contacts the switch element 25, a controller 20 detects that the switch formed by the sensor structure 10 and the switch element 25 is closed. That is, the controller 20 is connected by conductive signal lines to both the switch element 25 and the sensor structure 10. The sensor structure 10 can be made of a conductive material or otherwise include a conductive material so that the switch is closed when the sensor structure 10 contacts the switch element 25. The sensor structure 10 need not actually physically contact the switch element 25 so that the controller 20 can detect movement of the sensor structure 10. For example, the switch element 25 may be a field effect transistor that is turned on when the sensor structure 10 becomes charged and moves closely enough to the switch element 25 to act as a gate electrode and turn on the transistor. The controller 20 may reset the particle detection device by discharging the sensor structure 10 through a conductive line that communicates with the sensor structure 10 and allows the structure 10 to move back to an undeformed state. As will be understood by those of skill in the art, the switch element 25 can include other micro switch devices that are physically or electrically activated by the sensor structure 10.

Figure 11 shows another arrangement for detecting deflection of a sensor structure 10. In this example, a controller 20 detects movement of the sensor structure 10 by detecting changes in capacitance between a capacitor element 26 and the sensor structure 10. The capacitor element 26 can be a first capacitor plate that is formed by a metal layer or other conductive material formed in or on the substrate 14. The sensor structure 10 acts as or otherwise includes a second capacitor plate. That is, the sensor structure 10 or a portion of the sensor structure 10 can be made of a conductive material or otherwise include a conductive material so that the sensor structure 10 and the capacitor element 26 together function as a capacitor. As is well-known, when the sensor structure 10 moves toward or away from the capacitor element 26, the corresponding change in capacitance can be detected by the controller 20. The detected change in capacitance can be used to determine the amount and direction of deflection of the sensor structure 10, and thus can represent the number of particles, size of particles, charged particle density, etc. that impacts the sensor structure 10.

Figure 12 shows an alternate arrangement for detecting charged particles. A semiconductor substrate 14, such as a polysilicon or single crystalline silicon substrate includes conductive contacts 27, which can be made of metal or other conductive material having a higher conductivity than the substrate 14. When charged particles impact the substrate 14, the charged particles cause secondary electron emission from the substrate 14 material. The emitted electrons are collected by the contacts 27 and detected by a controller 20. As shown in Figure 12, the contacts 27 can be connected together by a common lead to the controller 20. Alternately, each of the contacts 27 can be individually connected to the controller so that the controller 20 can detect particle impact (secondary electron emission) as well as a position on the substrate 14 where the particle impacts. The controller 20 can also be arranged so that distinctions can be made between the impact of relatively small particles and relatively larger particles. For example, an ion beam containing mainly individual ions will cause the contacts 27 to detect a relatively constant level of electrons emitted by secondary electron emission. However, when a relatively larger particle, e.g., a group of thousands of ions, impacts the substrate 14, a larger number of electrons will be emitted and picked up by the contacts 27. Thus, when a surge in current through the contacts 27 is detected, a relatively larger particle has struck the substrate 14. The controller 20 detects the variation in current by connecting the array of contacts 27 either individually or in one or more groups, to ground through known current sensing circuitry.

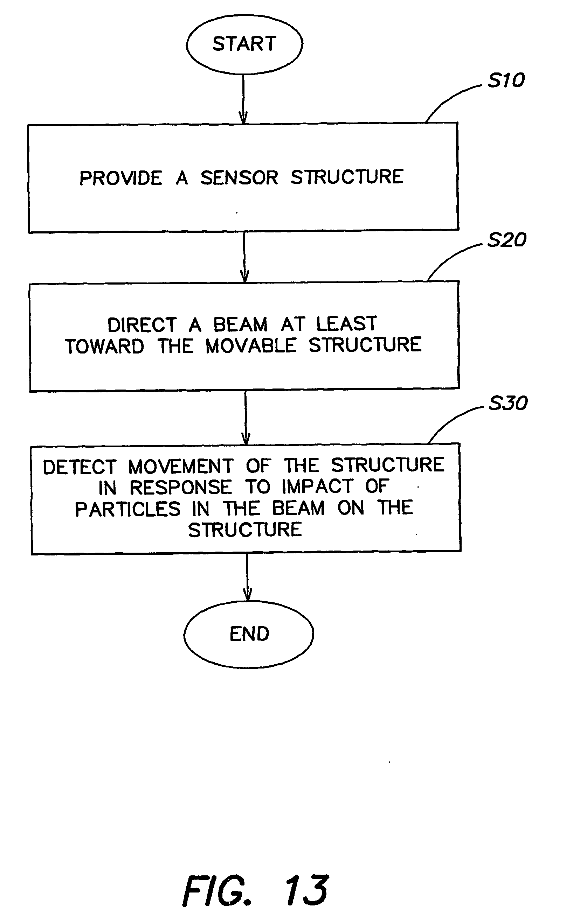

Figure 13 is a flowchart of steps of a method for detecting particles in a beam. In step S 10, a sensor structure is provided. The sensor structure can have various configurations as described above. For example, the sensor structure can include a fixed portion attached to a substrate and a movable portion that moves in response to particles impacting the movable portion. The particular size and shape of the sensor structure can vary, depending upon factors including the size and/or charge of particles to be detected, the sensitivity of the sensor structure, the particular environment in which the sensor structure is to be deployed, etc. For example, a relatively sensitive sensor structure could be provided for detecting the impact of relatively small particles, such as individual atoms or groups of atoms. Similarly, if the presence of a particle or particles is to be detected by momentum transfer of the particle or particles to the sensor structure, a more sensitive sensor structure is typically provided as compared to applications where the sensor structure is intended to detect particles based on electrical charge transferred and accumulated on the sensor structure.

In step S20, a beam is directed toward the sensor structure. The beam can be any type of beam, including a charged particle beam, an uncharged particle beam, etc. Directing the beam toward the sensor structure will typically cause one or more particles in the beam to impact the sensor structure. Impact of one or more particles on the sensor structure can cause either a momentum transfer from the particle to the sensor structure and/or electrical charge transfer to the sensor structure.

In step S30, movement of the sensor structure in response to impact of the one or more particles is detected. Movement of the structure can be detected in various ways, including detecting a change in direction of reflection of a light beam, such as a laser beam reflected by the sensor structure, detecting a closing or opening of a switching device caused by movement of the sensor structure, detecting a change in capacitance of a capacitor caused by movement of the structure, etc. Other possibilities exist for detecting the movement of a sensor structure, including detecting a change in resistance of a strain gage associated with the sensor structure, detecting a signal output by a piezoelectric element associated with the sensor structure and other possibilities as will be understood by those of skill in the art. Detecting movement of the structure can be used to determine a number of particles that impacted the structure, a particular type and/or size of particle that impacted the structure, a total charge amount transferred to the structure, a charge density of particles in the beam, a number of relatively large particles that are present in an ion beam, etc.

While the invention has been described in conjunction with specific embodiments thereof, it is evident that many alternatives, modifications and variations will be apparent to those skilled in the art. Accordingly, preferred embodiments of the invention as set Forth herein are intended to be illustrative, not limiting.

## Claims

1. A method for detecting ion in an ion beam, comprising:
providing at least one cantilever arm having a fixed portion (11) fixed relative to a substrate (14) and a movable portion (12) movable relative to the substrate (14);
directing an ion beam suitable for implanting ions in a semiconductor wafer toward the cantilever arm; **characterised by**
detecting movement of the movable portion (12) relative to the substrate (14) in response to ions in the ion beam changing an electrical charge of at least a portion of the cantilever arm.

2. The method of claim 1, wherein the step of detecting movement comprises detecting movement of the movable portion (14) of the cantilever arm based on electrostatic deflection of the arm.

3. The method of claim 1, wherein the step of detecting movement comprises detecting movement of the movable portion (14) of the cantilever arm based on momentum transfer of the ions to the movable portion.

4. The method of any one of claims 1 to 3, wherein the step of detecting movement comprises:
directing a light beam (23) at a portion of the cantilever arm; and
detecting a change in direction of a reflected light beam.

5. The method of claim 4, wherein the step of detecting movement comprises directing a first light beam (23-1) at a corresponding first cantilever arm (10-1) and directing a second light beam (23-2) at a corresponding second cantilever arm (10-2); and
detecting a change in distance between portions of a detector illuminated by reflected light beams.

6. A method of any one of claims 1 to 3, wherein the step of detecting movement comprises:
detecting an activation of a switching element (25).

7. The method of claim 6, wherein the step of detecting an activation comprises detecting the closing of a circuit portion between the cantilever arm and a contact pad.

8. A particle detector (100) for use with an ion implantation device, the particular detector comprising:
at least one sensor structure (10), each sensor structure having a fixed portion (11) fixed relative to a reference surface (14) and a movable portion (12); **characterised by**
a sensor (21, 22; 26) that detects movement of the movable portion of the sensor structure in response to ions in an ion beam suitable for implanting in a semiconductor wafer impacting the sensor structure and changing an electrical charge of the sensor structure.

9. The particle detector of claim 8, wherein the sensor structure includes at least one cantilever arm.

10. The particle detector of any one of claims 8 and 9, wherein the sensor detects movement of the sensor structure based on electrostatic deflection of the movable portion (12) of the sensor structure.

11. The particle detector of any one of claims 8 to 10, wherein the sensor comprises:
a light beam emitter (21) that emits a light beam toward a portion of the sensor structure; and
a light detector (22) that outputs a signal indicative of a change in direction of a light beam reflected by the sensor structure.

12. The particle detector of any one of claims 8 to 10, wherein the sensor comprises:
a switching element (26) that outputs a signal when activated by movement of the movable portion of the sensor structure.

13. The particle detector of any one of claims 8 to 10, wherein the sensor comprises:
a capacitor element that acts together with a portion of the sensor structure (12) to form a capacitor, a capacitance of the capacitor varying with movement of the sensor structure.

14. The particle detector of any one of claims 8 to 13, wherein the sensor structure comprises:
at least two cantilever arms (16), each cantilever arm having a fixed end fixed relative to a substrate and a free end; and
a pad (17) that is supported by the free ends of the at least two cantilever arms.

15. The particle detector of any one of claims 8 to 13, wherein the sensor structure comprises:
a substrate (14) having a cavity (15) formed in an upper surface of the substrate; and
a bridge structure (10) fixed to the upper surface of the substrate at opposite ends of the cavity.

16. An ion implantation device comprising:
the particle detector of any one of claims 8 to 15; and
an ion beam generator;
wherein the sensor structure is positioned near a workpiece plane to detect particles in an ion beam produced by the ion beam generator.

## Patentansprüche

1. Verfahren zum Erfassen von Ionen in einem Ionenstrahl, welches umfaßt:
Bereitstellen mindestens eines Auslegers mit einem feststehenden Abschnitt (11), der relativ zu einem Substrat (14) fixiert ist, und einem beweglichen Abschnitt (12), der relativ zum Substrat (14) beweglich ist;
Ausrichten eines Ionenstrahls, der geeignet ist, um Ionen in einen Halbleiter-Wafer zu implantieren, auf den Ausleger; **gekennzeichnet durch**
Erfassen der Bewegung des beweglichen Abschnitts (12) relativ zum Substrat (14) als Antwort auf Ionen im Ionenstrahl, welche die elektrische Ladung mindestens eines Teils des Auslegers ändern.

2. Verfahren nach Anspruch 1, wobei der Schritt der Bewegungserfassung das Erfassen der Bewegung des beweglichen Abschnitts (14) des Auslegers aufgrund einer elektrostatischen Auslenkung des Arms umfaßt.

3. Verfahren nach Anspruch 1, wobei der Schritt der Bewegungserfassung das Erfassen der Bewegung des beweglichen Abschnitts (14) des Auslegers aufgrund der Übertragung des Moments der Ionen auf den beweglichen Abschnitt umfaßt.

4. Verfahren nach irgendeinem der Ansprüche 1 bis 3, wobei der Schritt der Bewegungserfassung folgendes umfaßt:
Ausrichten eines Lichtstrahls (23) auf einen Abschnitt des Auslegers; und
Erfassen einer Richtungsänderung eines reflektierten Lichtstrahls.

5. Verfahren nach Anspruch 4, wobei der Schritt der Bewegungserfassung das Ausrichten eines ersten Lichtstrahls (23-1) auf einen entsprechenden ersten Ausleger (10-1) und das Ausrichten eines zweiten Lichtstrahls (23-2) auf einen entsprechenden zweiten Ausleger (10-2) umfaßt, sowie
das Erfassen einer Änderung des Abstands zwischen Abschnitten eines Detektors, die von reflektierten Lichtstrahlen beleuchtet werden.

6. Verfahren nach einem der Ansprüche 1 bis 3, wobei der Schritt der Bewegungserfassung folgendes umfaßt:
Erfassen der Aktivierung eines Schaltelements (25).

7. Verfahren nach Anspruch 6, wobei der Schritt des Erfassens einer Aktivierung das Erfassen des Schließens eines Schaltungsabschnitts zwischen dem Ausleger und einem Kontaktpad einschließt.

8. Teilchendetektor (100) zur Verwendung mit einer Ionenimplantationseinrichtung, wobei der Teilchendetektor folgendes einschließt:
mindestens einen Sensoraufbau (10), wobei jeder Sensoraufbau einen feststehenden Abschnitt (11) einschließt, der relativ zu einer Bezugsoberfläche (14) fixiert ist, sowie einen beweglichen Abschnitt (12), **gekennzeichnet durch**
einen Sensor (21, 22; 26), der die Bewegung des beweglichen Abschnitts des Sensoraufbaus als Antwort auf Ionen in einem Ionenstrahl erfaßt, der zur Implantation in einem Halbleiter-Wafer geeignet ist und der auf den Sensoraufbau trifft und die elektrische Ladung des Sensoraufbaus ändert.

9. Teilchendetektor nach Anspruch 8, wobei der Sensoraufbau mindestens einen Ausleger einschließt.

10. Teilchendetektor nach einem der Ansprüche 8 und 9, wobei der Sensor die Bewegung der Sensoraufbaus aufgrund der elektrostatischen Auslenkung des beweglichen Abschnitts (12) des Sensoraufbaus erfaßt.

11. Teilchendetektor nach einem der Ansprüche 8 bis 10, wobei der Sensor die einschließt:
einen Lichtstrahlemitter (21), der einen Lichtstrahl auf einen Abschnitt des Sensoraufbaus emittiert; und
einen Lichtdetektor (22), der ein Signal ausgibt, das eine Änderung der Richtung des Lichtstrahls, der vom Sensoraufbau reflektiert wird, aussendet.

12. Teilchendetektor nach einem der Ansprüche 8 bis 10, wobei der Sensor umfaßt:
ein Schaltelement (26), das ein Signal aussendet, wenn es durch die Bewegung des beweglichen Abschnitts des Sensors aktiviert wurde.

13. Teilchendetektor nach einem der Ansprüche 8 bis 10, wobei der Sensor folgendes einschließt:
ein Kondensatorelement, das mit einem Teil des Sensoraufbaus (12) zusammenwirkt, um einen Kondensator zu bilden, wobei die Kapazität des Kondensators mit der Bewegung des Sensoraufbaus variiert.

14. Teilchendetektor nach einem der Ansprüche 8 bis 13, wobei der Sensoraufbau folgendes einschließt:
mindestens zwei Ausleger (16), wobei jeder Ausleger ein feststehendes Ende hat, das relativ zu einem Substrat fixiert ist, sowie ein freies Ende; und
ein Pad (17), das von den freien Enden der mindestens zwei Ausleger gestützt wird.

15. Teilchendetektor nach einem der Ansprüche 8 bis 13, wobei der Sensoraufbau folgendes einschließt:
ein Substrat (14) mit einem Hohlraum (15), der an der Oberseite des Substrats ausgebildet ist; und
einen Brückenaufbau (10), der an der Oberfläche des Substrats an gegenüberliegenden Enden des Hohlraums befestigt ist.

16. Ionenimplantationsvorrichtung, welche einschließt:
den Teilchendetektor nach einem der Ansprüche 8 bis 15; und
einen Ionenstrahlerzeuger;
wobei der Sensoraufbau in der Nähe einer Werkstückebene angeordnet ist, um Teilchen in einem Ionenstrahl zu erfassen, die von dem Ionenstrahlerzeuger erzeugt werden.

## Revendications

1. Procédé pour détecter un ion dans un faisceau d'ions, consistant à :
prévoir au moins un bras en porte-à-faux comportant une partie fixe (11) fixée par rapport à un substrat (14) et une partie mobile (12) pouvant se déplacer par rapport au substrat (14) ;
diriger un faisceau d'ions adapté pour l'implantation d'ions dans une plaquette à semi-conducteur vers le bras en porte-à-faux ; **caractérisé par**
la détection du mouvement de la partie mobile (12) par rapport au substrat (14) en réponse à des ions dans le faisceau d'ions changeant une charge électrique d'au moins une partie du bras en porte-à-faux.

2. Procédé selon la revendication 1, dans lequel l'étape consistant à détecter un mouvement comprend la détection du mouvement de la partie mobile (14) du bras en porte-à-faux sur la base de la déflexion électrostatique du bras.

3. Procédé selon la revendication 1, dans lequel l'étape consistant à détecter un mouvement comprend la détection du mouvement de la partie mobile (14) du bras en porte-à-faux sur la base du transfert de la force d'impulsion des ions vers la partie mobile.

4. Procédé selon l'une quelconque des revendications 1 à 3, dans lequel l'étape de détection d'un mouvement consiste à :
diriger un faisceau lumineux (23) au niveau d'une partie du bras en porte-à-faux ; et
détecter un changement de direction d'un faisceau lumineux réfléchi.

5. Procédé selon la revendication 4, dans lequel l'étape de détection d'un mouvement consiste à diriger un premier faisceau lumineux (23-1) au niveau d'un premier bras en porte-à-faux correspondant (10-1) et à diriger un second faisceau lumineux (23-2) au niveau d'un second bras en porte-à-faux correspondant (10-2) ; et
à détecter un changement de la distance entre des parties d'un détecteur éclairé par des faisceaux lumineux réfléchis.

6. Procédé selon l'une quelconque des revendications 1 à 3, dans lequel l'étape consistant à détecter un mouvement comprend :
la détection d'une activation d'un élément de commutation (25).

7. Procédé selon la revendication 6, dans lequel l'étape consistant à détecter une activation comprend la détection de la fermeture d'une partie de circuit entre le bras en porte-à-faux et une pastille de contact.

8. Détecteur de particules (100) pour une utilisation avec un dispositif d'implantation d'ions, le détecteur de particules comprenant :
au moins une structure de capteur (10), chaque structure de capteur comportant une partie fixe (11) fixée par rapport à une surface de référence (14) et une partie mobile (12) ; **caractérisé par**
un capteur (21, 22 ; 26) qui détecte le mouvement de la partie mobile de la structure de capteur en réponse à des ions dans un faisceau d'ions adapté pour une implantation dans une plaquette à semi-conducteur venant percuter la structure de capteur et changeant une charge électrique de la structure de capteur.

9. Détecteur de particules selon la revendication 8, dans lequel la structure de capteur comprend au moins un bras en porte-à-faux.

10. Détecteur de particules selon l'une quelconque des revendications 8 et 9, dans lequel le capteur détecte un mouvement de la structure de capteur sur la base d'une déflexion électrostatique de la partie mobile (12) de la structure de capteur.

11. Détecteur de particules selon l'une quelconque des revendications 8 à 10, dans lequel le capteur comprend :
un émetteur de faisceau lumineux (21) qui émet un faisceau lumineux vers une partie de la structure de capteur ; et
un détecteur de lumière (22) qui délivre un signal indiquant un changement de direction d'un faisceau lumineux réfléchi par la structure de capteur.

12. Détecteur de particules selon l'une quelconque des revendications 8 à 10, dans lequel le capteur comprend :
un élément de commutation (26) qui délivre un signal lorsqu'il est activé par un mouvement de la partie mobile de la structure de capteur.

13. Détecteur de particules selon l'une quelconque des revendications 8 à 10, dans lequel le capteur comprend :
un élément de condensateur qui agit conjointement avec une partie de la structure de capteur (12) pour former un condensateur, une capacité du condensateur variant avec le mouvement de la structure de capteur.

14. Détecteur de particules selon l'une quelconque des revendications 8 à 13, dans lequel la structure de capteur comprend :
au moins deux bras en porte-à-faux (16), chaque bras en porte-à-faux comportant une extrémité fixe fixée par rapport à un substrat et une extrémité libre ; et
une pastille (17) qui est supportée par les extrémités libres des au moins deux bras en porte-à-faux.

15. Détecteur de particules selon l'une quelconque des revendications 8 à 13, dans lequel la structure de capteur comprend :
un substrat (14) comportant une cavité (15) formée dans une surface supérieure du substrat ; et
une structure de pont (10) fixée à la surface supérieure du substrat au niveau des extrémités opposées de la cavité.

16. Dispositif d'implantation d'ions comprenant :
le détecteur de particules selon l'une quelconque des revendications 8 à 15 ; et
un générateur de faisceau d'ions ;
dans lequel la structure de capteur est positionnée près d'un plan d'une pièce à travailler pour détecter des particules dans un faisceau d'ions produit par le générateur de faisceau d'ions.
